(19) **Europäisches Patentamt**

**European Patent Office**

**Office européen des brevets**

(11) Publication number: **0 289 117 B1**

(12) **EUROPEAN PATENT SPECIFICATION**

(45) Date of publication of patent specification: **16.06.93**  (51) Int. Cl.5: **C30B 25/02**, C30B 25/18

(21) Application number: **88301840.0**

(22) Date of filing: **02.03.88**

(54) Method of forming crystals on a substrate.

(30) Priority: **02.03.87 JP 47032/87**

(43) Date of publication of application:
**02.11.88 Bulletin 88/44**

(45) Publication of the grant of the patent:
**16.06.93 Bulletin 93/24**

(84) Designated Contracting States:
**DE FR GB IT NL**

(56) References cited:
EP-A- 0 180 751
EP-A- 0 244 081
EP-A- 0 281 335

JOURNAL OF CRYSTAL GROWTH, vol. 77,
nos. 1-3, September 1986, pages 524-529,
Elsevier Science Publishers B.V., Amsterdam, NL; A. SUGIMURA et al.:
"Heteroepitaxial growth of GaAs on sapphire
substrates by a three-step method using low
pressure MOCVD"

(73) Proprietor: **CANON KABUSHIKI KAISHA**
**30-2, 3-chome, Shimomaruko, Ohta-ku**
**Tokyo(JP)**

(72) Inventor: **Yonehara, Takao**
**1309, Onna**
**Atsugi-shi Kanagawa-ken(JP)**

(74) Representative: **Beresford, Keith Denis Lewis**
**et al**
**BERESFORD & Co. 2-5 Warwick Court High**
**Holborn**
**London WC1R 5DJ (GB)**

THIN SOLID FILMS, vol. 115, no. 3, May 1984, pages 237-243, Elsevier Sequoia, Lausanne, CH; A.G. ABDULLAYEV et al.: "The simultaneous growth of monocrystalline and polycrystalline silicon films with controlled parameters"

BRITISH JOURNAL OF APPLIED PHYSICS, vol. 18, no. 10, October 1967, pages 1357-1382, GB; J.D. FILBY et al.: "Single-crystal films of silicon on insulators"

RCA REVIEW, vol. 44, no. 2, June 1983, pages 250-269, Princeton, New Jersey, US; L. JASTRZEBSKI: "Comparison of different SOI technologies: assets and liabilities"

JOURNAL OF THE ELECTROCHEMICAL SOCIETY, vol. 132, no. 11, November 1985, pages 2748-2758, Manchester, New Hampshire, US; L.O. WILSON et al.: "Lateral epitaxial growth over oxide"

JOURNAL OF APPLIED PHYSICS, vol. 55, no. 2, 15th January 1984, pages 519-523, American Institute of Physics, Woodbury, New York, US; D.R. BRADBURY et al.: "Control of lateral epitaxial chemical vapor deposition of silicon over insulators"

**Description**

BACKGROUND OF THE INVENTION

Field of the Invention

This invention relates to a method of forming crystals and crystalline articles obtained by said method, particularly to a method for forming monocrystals or polycrystals controlled in grain size and grain size distribution prepared by utilizing the nucleation density difference ($\Delta ND$) of the built-up materials depending on the kind of the built-up face materials.

The present invention may be applied for formation of monocrystals, polycrystals, etc. to be used for, for example, electronic devices, optical devices, magnetic devices, piezoelectric devices or surface acoustic devices, etc. such as semiconductor integrated circuit, optical integrated circuit, magnetic circuit, etc.

Related Background Art

In the prior art, monocrystalline thin films used for semiconductor electronic devices, optical devices, etc. have been formed by epitaxial growth on a monocrystalline substrate. For example, on a Si monocrystalline substrate (silicon wafer), Si, Ge, GaAs, etc. have been known to be epitaxially grown from liquid phase, gas phase or solid phase, and also on a GaAs monocrystalline substrate, monocrystals of GaAs, GaAlAs, etc. have been known to be epitaxially grown. By use of the semiconductor thin film thus formed, semiconductor devices and integrated circuits, emission devices such as semiconductor laser or LED are prepared.

Also, in recent years, researches and developments have been abundantly done about ultra-high speed transistor by use of two-dimensional electron gas, superlattice device utilizing quantum well, etc., and these have been made possible by high precision epitaxial technique such as MBE (molecular beam epitaxy) by use of ultra-high vacuum, MOCVD (metal organic chemical vapor deposition), etc.

In such epitaxial growth on a monocrystalline substrate, it is required to adjust the lattice constant and coefficient of thermal expansion between a monocrystalline material of the substrate and an epitaxial growth layer. For example, although it is possible to grow epitaxially a Si monocrystalline thin film on sapphire which is an insulating monocrystalline substrate, the crystal lattice defect at the surface due to deviation in lattice constant and diffusion of aluminum which is the component of sapphire into the epitaxial layer, etc. are becoming problems in application to electronic devices or electronic circuit devices.

Thus, it can be understood that the method of forming a monocrystalline thin film of the prior art according to epitaxial growth depends greatly on its substrate material. Mathews et al examined the combinations of the substrate materials with the epitaxial growth layers (EPITAXIAL GROWTH, Academic Press, New York, 1975 ed. by J.W.Mathews).

Also, the size of the substrate is presently about 6 inches for Si wafer, and enlargement of GaAs, sapphire substrate is further delayed. In addition, since the production cost of a monocrystalline substrate is high, the cost per chip becomes high.

Thus, for forming a monocrystalline layer capable of preparing a device of good quality according to the process of the prior art, there has been the problem that the kinds of the substrate material are limited to an extremely narrow scope.

On the other hand, in recent years, researches and developments have been extensively done on the three-dimensional integrated circuits formed by laminating semiconductor devices in the normal direction of a substrate to achieve a highly integrated and polyfunctional state. Researches and developments are also extensively being made year by year on large area semiconductor devices in which elements are set in array on an inexpensive glass, such as solar batteries and switching transistors for liquid crystal display devices.

What is common to these researches and developments is to require techniques by which a semiconductor thin film is formed on an amorphous insulating material and an electronic device such as a transistor is formed thereof. Particularly sought after among these is a technique by which a monocrystalline semiconductor of high quality is formed on an amorphous insulating material.

In general, however, the build-up of a thin film on the amorphous insulating material such as $SiO_2$ may generally make amorphous or polycrystalline the crystalline structure of the built-up film because of lack of long-distance order of the substrate material. Here, the amorphous film refers to a film kept in a state that the short-distance order as in most vicinal atoms is retained but there is no long-distance order more than that, and the polycrystalline film refers to a film in which monocrystalline grains having no particular crystal direction have gathered in a manner separated at the grain boundaries.

For example, when Si is formed on a $SiO_2$ substrate by the CVD method, if the deposition temperature is about 600 °C or lower, an amorphous silicon is formed, while at a temperature higher than that, a polycrystalline silicon with grain sizes distributed between some ten to some hundred nm (some hundred to some thousand Å) is formed. However, the grain size and its distribution will vary greatly depending on the formation method.

Further, a polycrystalline thin film with a large grain size of about micron or millimeter is obtained by melting and solidifying an amorphous or polycrystalline film with an energy beam such as laser, rod-shaped heater, etc. (Single-Crystal silicon on non-single-crystal insulators, Journal of Crystal Growth vol. 63, No.3, October, 1983, edited by G.W. Cullen).

When transistors are formed on thin films of various crystal structures thus formed, and electron mobility is measured from its characteristics, a mobility of ca. 0.1 $cm^2$/V.sec is obtained for amorphous silicon, a mobility of 1 to 10 $cm^2$/V.sec for a polycrystalline silicon having a grain size of some ten nm (hundred Å), and a mobility to the same extent as in the case of monocrystalline silicon for a polycrystalline silicon with a large grain size by melting and solidification.

From these results, it can be understood that there is great difference in electrical characteristics between the element formed in the monocrystalline region within the crystal grain and the element formed as crossing over the grain boundary. In other words, the built-up film on the amorphous material obtained according to the prior art method becomes amorphous or a polycrystalline structure having grain size distribution, and the device prepared there is greatly inferior in performance as compared with the device prepared in the monocrystalline layer. For this reason, uses are limited to simple switching element, solar battery, photoelectric converting element, etc.

Also, the method for forming a polycrystalline thin film with a large grain size by melting and solidification has the problem that enormous time is required for making grain size larger, because an amorphous or monocrystalline thin film is scanned with an energy beam for each wafer, whereby bulk productivity is poor and the method is not suited for enlargement of area.

As described above, in the crystal growth method of the prior art and the crystal formed thereby, three-dimensional integration or area enlargement cannot be easily done, and practical application for a device has been difficult, whereby a crystal such as monocrystals and polycrystals, etc. required for preparing a device having excellent characteristics cannot be formed easily and at low cost.

European Patent Application EP-A-0281335 here mentioned with reference to Article 54(3) EPC discloses a method of forming a crystal on a substrate having a nucleation surface of amorphous material and a nonnucleation surface in a film forming space, the nucleation surface having a larger nucleation density than the nonnucleation surface and an area small enough to support the formation of only a single nucleus from which a single crystal can be grown. During the growth phase of this method, that is the phase that follows formation of the single nucleus, the growth conditions are changed, for example there is a change in the type and quantity of dopant material introduced with the deposited film forming material so that a pn diode structure or the like can be produced.

In accordance with the present invention there is provided a method of forming a crystal on a substrate having a nucleation surface of amorphous material and a nonnucleation surface in a film forming space, the nucleation surface having a larger nucleation density than the nonnucleation surface, and an area small enough to support the formation of only a single nucleus from which a single crystal can be grown, said method comprising:

forming said single nucleus on the nucleation surface of said substrate using a chemical vapor deposition method by introducing a crystal forming gas and a nucleation suppressing gas into the film forming space, the ratio of crystal forming gas to nucleation suppressing gas being sufficient to effect formation of said single nucleus on said nucleation surface; and

increasing the amount of said nucleation suppressing gas to inhibit growth on said non-nucleation surface, and effecting growth of said single crystal by growing single crystal material from said single nucleus on said nucleation surface.

As used herein the term "nucleation density" refers to that number of nuclei of the single crystal material that would be formed on a unit area of surface. The expression "a surface having a nucleation density" shall be construed accordingly.

It is found as discussed below that a nucleation surface size of 10 $\mu$m or less is in general sufficient to support the formation of only a single nucleus from which single crystal can be grown.

The invention defined above is intended to provide a solution to some at least of the problems of the prior art that have just been discussed.

Embodiments of the invention serve to provide methods of forming crystals of good quality such as monocrystals containing no grain boundary and polycrystal having grain boundaries controlled in size and distribution, etc. without restriction as to the base material, for example without restriction to the composition, constitution or size of the substrate.

It has been found that the invention can be performed using only simple steps and it can be so performed with good efficiency without resort to sophisticated apparatus. Yield of quality crystal material has been found to be high and this method therefore looks to be promising for industrial scale processing.

BRIEF DESCRIPTION OF THE DRAWINGS

Fig. 1 is a graph showing the manner of change of the free energy G.

Figs. 2(A) and 2(B) illustrate the selective build-up method.

Fig. 3 is a graph showing the change of nucleation density (ND) on build-up surfaces of $SiO_2$ and silicon nitride.

Figs. 4(A) - 4(D) illustrate an example of the monocrystal forming method described in Japanese Patent Application No. 153273/1986.

Figs. 5(A) and 5(B) are perspective views of Figs. 4(A) and 4(D).

Figs 6(A) - 6(D) illustrate the first embodiment of the crystal forming method of the present invention.

Figs. 7 - 10 illustrate four examples of substrate constitution.

Figs. 11(A) - 11(C) illustrate the process from the nucleation step to the crystal growth step. Fig. 12 illustrates the result of the formation of a happening nucleus.

Figs. 13(A) and 13(B) illustrate the process of the experiment leading to the present invention.

Figs. 14(A) - 14(C) illustrate the second embodiment of the crystal forming method of the present invention.

DESCRIPTION OF THE PREFERRED EMBODIMENTS

First, for better understanding of the present invention, general thin film forming process of a metal or a semiconductor is to be explained.

When the built-up face is of a material different in kind from the flying atoms, particularly an amorphous material, the flying atoms will be freely diffused on the substrate (built-up surface) and reevaporated (eliminated). And, as the result of collision mutually between the atoms, a nucleus is formed, and when the nucleus reaches the size rc ($= -2\sigma_0$ gv) at which its free energy G becomes the maximum (critical nucleus), G is reduced and the nucleus continues to grow stably three-dimensionally and become shaped in an island. The nucleus with a size exceeding rc is called "stable nucleus" and in the basic description of the present invention hereinbelow, "nucleus" unless otherwise specifically noted indicates the "stable nucleus".

Also, of the "stable nucleus", one with small r is called "initial nucleus". The free energy G formed by formation of the nucleus is represented by:

$$G = 4\pi f(\theta)(\sigma_0 r^2 + 1/3 \text{ gv } r^3)$$

$$f(\theta) = 1/4(2 - 3 \cos\theta + \cos^2\theta )$$

where

r:      radius of curvature of nucleus

$\theta$ :      contact angle of nucleus

gv:      free energy per unit deposition

$\sigma_0$:      surface energy between nucleus and vacuum.

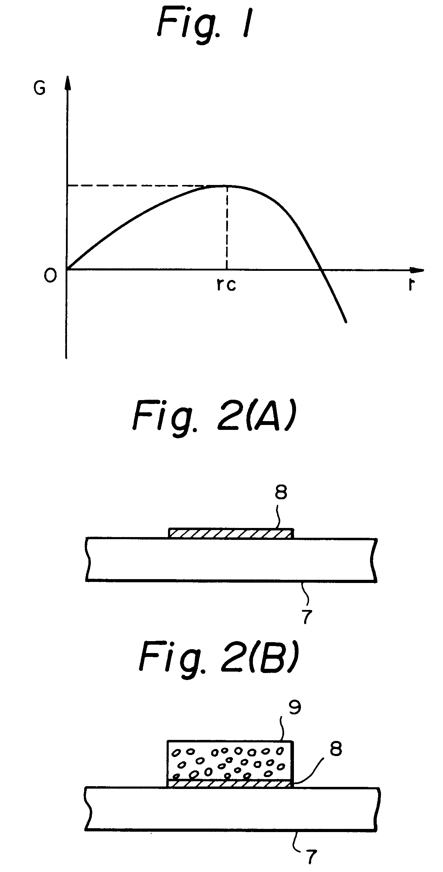

The manner in which G is changed is shown in Fig. 1. In the same Figure, the curvature of radius of the stable nucleus when G is at the maximum value is rc.

Thus, the nucleus grows to become shaped in an island, and further grows until contact mutually between islands proceeds, giving rise to coalescence in some cases, finally forming via a network structure a continuous film to cover completely the substrate surface. Through such process, a thin film is built up on the substrate.

In the build-up process as described above, the density of the nucleus formed per unit area of the substrate surface, the size of the nucleus and the nucleation speed are determined depending on the state of the build-up system, and particularly the interaction between the flying atoms and the substrate surface substance is an important factor. Also, a specific crystal direction grows in parallel to the substrate depending on the anisotropy relative to the crystal face of the interfacial energy at the interface between the built-up substrate and the substrate, and when the substrate is amorphous, the crystal directions within the substrate plane are not constant. For this reason, a grain boundary is formed by collision mutually between nuclei or islands. Particularly, in the case of collision mutually between islands with certain sizes or greater, coalescence will occur, leading directly to formation of a grain boundary. The grain boundary formed can be migrated with difficulty in the solid phase, and therefore the grain size is determined at that point.

Referred next is a selective build-up process for selectively forming a build-up film on a build-up face. The selective build-up process is a process for selectively forming a thin film on a substrate surface by utilizing a difference between materials in the factors such as surface energy, adhesion constant, elimination coefficient and surface diffusion coefficient that may influence the nucleation in the course of the thin-film formation.

Figs. 2(A) and 2(B) are explanatory views of the selective build-up process.

First, as shown in (A) of the figures, on a substrate 7, a thin film 8 comprising a material having differences in the above factors from the substrate 7 is formed on a desired part. Then, the build-up of a thin film comprising a suitable material may be carried out under suitable build-up conditions, whereby there can be caused the phenomenon that a thin film 9 is formed only on the thin film 8 and no growth takes place on the substrate 7. Utilizing this phenomenon, it is possible to allow the self-adjustably formed thin film 9 to grow, thus making it possible to omit the conventionally required lithography step in which a resist is used.

The material on which the build-up according to such a selective formation process can be carried out includes, for example, $SiO_2$ as the substrate 7, Si, GaAs and silicon nitride as the thin film 8, and Si, W, GaAs, InP, etc. as the thin film 9 to be built-up.

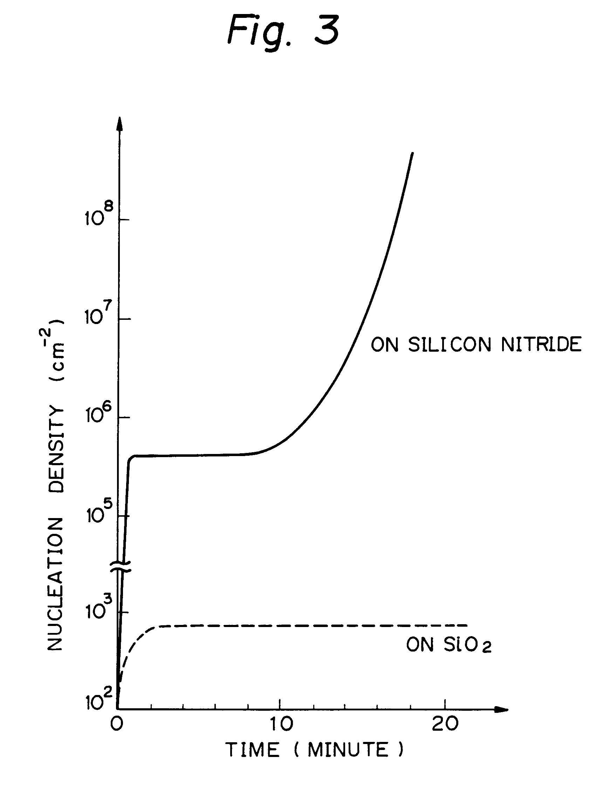

Fig. 3 is a graph showing changes with time in the nucleation density (ND) of the build-up face of $SiO_2$ and that of the build-up face of silicon nitride.

As shown by the graph, the nucleation density (ND) on $SiO_2$ build-up surface is saturated at $10^3$ cm$^{-2}$ or less soon after the build-up was started, with little change in its value even after 20 minutes.

In contrast thereto, on the silicon nitride ($Si_3N_4$) build-up surface, the nucleation density is saturated once at less than $4 \times 10^5$ cm$^{-2}$ with no change thereafter for about 10 minutes, but abruptly increases thereafter. In this measurement example, demonstrated are instances in which the build-up was carried out according to CVD process by diluting $SiCl_4$ gas with $H_2$ gas and under the conditions of 175 Torr in pressure and 1,000°C in temperature. Besides this, similar operations can be achieved by using $SiH_4$, $SiH_2Cl_2$, $SiHCl_3$, $SiF_4$, etc. as the reactant gas and controlling the pressure, temperature, etc. Also possible is the vapor deposition.

In the present instance, although there is little problem in the nucleation on $SiO_2$ build-up surface, the addition of HCl gas in the reactant gas can further suppress the nucleation on $SiO_2$ build-up surface so that no Si at all may be built up on $SiO_2$ build-up surface.

Such a phenomenon greatly depends on the differences in the adsorption coefficient, elimination coefficient, surface diffusion coefficient, etc. to Si present on the material faces of $SiO_2$ and silicon nitride. However, it is considered that another cause by which the selective build-up occurs in that $SiO_2$ is reacted by Si atoms themselves to form silicon monoxide having a high vapor pressure, whereby $SiO_2$ itself it etched but such an etching phenomenon does not occur on silicon nitride (T. Yonehara, S. Yoshioka, S. Miyazawa, Journal of Applied Physics 53,6839, 1982).

In this manner, the selection of $SiO_2$ and silicon nitride as the materials for the build-up face and the selection of silicon as the material for the build-up material can attain the sufficiently great difference ($\Delta$ND) in nucleation density as shown in the graph. Here, $SiO_2$ is desirable as the material for the build-up face, but, without limitation thereto, the nucleation density difference can also be satisfactorily attained with use of $SiO_x$.

Of course, the material may not be limited to these materials. It is satisfactory if the difference in nucleation density is $10^2$ times or more in terms of the density of a nucleus, as shown in the graph, and the sufficient selective formation of the build-up film can be also carried out with use of the materials exemplified hereinbelow.

As another method of obtaining this nucleation density difference, the ion implantation of Si, N, etc. may be locally effected on $SiO_2$ to form a zone having Si, N, etc. excessively.

Such a selective build-up process based on the nucleation density difference ($\Delta$ND) is described in Japanese Patent Application No. 153273/1986. In an example of the selective build-up process, a build-up face (nucleation surface) of the heterogeneous material differred from the other build-up face having a sufficiently greater nucleation density than the material for the other build-up face may be formed in such a sufficiently fine state that a monocrystal may grow from only a single nucleus, whereby a monocrystal can be allowed to selectively grow from the part at which that fine nucleation surface of heterogeneous material exists.

Also, the selective growth of the monocrystal is determined by the state of electrons present on the surface of the build-up face, particularly by the state of dangling bond thereon. Accordingly, the material having a low nucleation density (for example, $SiO_2$) may not necessarily be a bulk material, but may also be satisfactory if it is provided only on the surface of supporting member of any material to constitute the above build-up face.

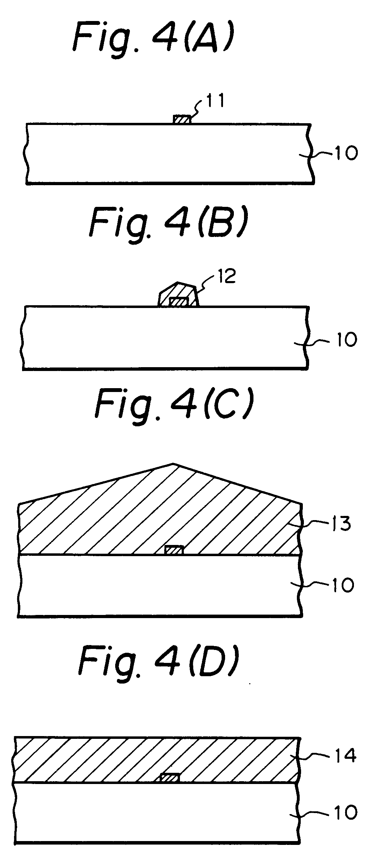

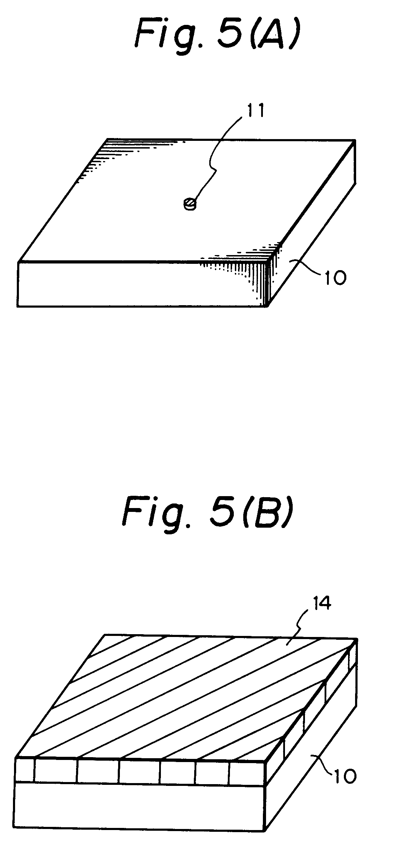

Figs 4(A) to 4(D) are formation step views illustrating an example of the method for forming a monocrystal described in the above-mentioned Japanese Patent Application No. 153273/1986, and Figs. 5-(A) and 5(B) are perspective views of the substrates seen in Figs. 4(A) and 4(D), respectively.

First, as shown in Fig. 4(A) and Fig. 5(A), a heterogeneous material differred from the substrate referred to below having a greater nucleation density is thinly built-up on a substrate 10 having a smaller nucleation density and enabling the selective build-up, and subjected to patterning by lithography or the like so as to form a nucleation surface of the heterogeneous material 11 in a sufficiently fine form.

As mentioned previously, the nucleation surface 11 is meant to include the modified zone excessively having Si, N, etc., formed by the ion implantation of Si, N, etc. on the substrate 10.

Next, a single nucleus of a semiconductor material such as Si, etc. is formed only on the nucleation surface 11 under suitable nucleation conditions. More specifically, the nucleation surface 11 is required to be formed in a sufficiently fine form such that only the single nucleus may be formed. The size of the nucleation surface 11 may vary depending on the kind of the material, but may be satisfactory if it is ten microns or less, preferably several microns or less. The nucleus further grows by subsequent crystal growth treatment while keeping the structure as a monocrystal, and turns to an islet-like monocrystal grain 12 as shown in Fig. 4(B). In order for the islet-like monocrystal grain 12 to be formed, it is necessary to select the conditions so that no nucleation may take place at all on the substrate 10, as previously mentioned.

The islet-like monocrystal grain 12 further grows around the nucleation surface 11 while keeping the structure as a monocrystal, and covers the whole of the substrate 10 as shown in (C) of the same Figure.

Subsequently, the monocrystal 13 is evened by etching or grinding, so that a monocrystal layer 14 with which a desired device can be formed is formed on the substrate 10 as shown in Fig. 4(D) and Fig. 5(B).

The present invention is to improve the crystal forming process as described above.

The method of forming a crystal, of the present invention will be described below.

What is aimed in the present invention is to prevent an additional nucleus around which a monocrystal may grow, from being formed on the exposed build-up face in the course where the single nucleus is formed on the nucleation surface and the monocrystal grows around this nucleus.

As mentioned previously, in instances in which the Si crystal is allowed to grow by thermal decomposition or $H_2$-reduction of the reactant gas such as $SiCl_4$ gas in an $H_2$-reductive atmosphere, it is known that addition of an additional gas HCl to the reactant gas makes it possible to cause no build-up of Si on $SiO_2$ build-up face, and this method is described, for example, in Joh O. Borland and Cifoord I. Drowley, "Improved Dielectric Material Separation Method by Selective Epitaxial Growth", Solid-state Technology, Japanese Language Edition, October 1985, P. 43.

However, in the above-mentioned method of forming a crystal, disclosed in Japanese Patent Application No. 153273/1986, there may occur a problem such that if the crystal growth is tried to be carried out by adding the additional gas to the reactant gas from the initial stage of crystal formation in order to suppress the formation of a nucleus of the crystal material on the build-up face, the single nucleus can be formed on the nucleation surface with difficulty.

The present invention is characterized in that the ratio of the additional gas (nucleation suppressing gas) to the reactant gas is as decreased as possible (or the additional gas is not added) or, the temperature is simultaneously controlled to a lower degree at the nucleation initial stage where the single nucleus is formed, whereby the condition is set to a condition under which the nucleation may readily take place to effectively form a single nucleus only on the nucleation surface, and, at the crystal growth stage where a monocrystal grows around the single nucleus, the ratio of the additional gas to the reactant gas is increased or, the temperature is simultaneously raised, whereby the condition is set to a condition under which the nucleation may not take place at all on the nonnucleation surface.

The present invention can be described as follows:

Assuming here respectively as X, Y and Z the adhesion coefficients of atoms of crystal materials on the respective faces of the crystal face, nucleation surface and nonnucleation surface, they have the following relationship:

$$X > Y \gg Z$$

At the initial nucleation stage, the exposed faces to the atoms of the crystal materials (material of crystal to be formed) are the nonnucleation surface and nucleation surface only. At this stage, the preparation conditions are set that the nucleation may be readily effected. This is because, although the conditions are so set in the direction such that the nucleation may also be readily effected in respect of the nonnucleation surface, the adhesion coefficient is $Y \gg Z$ and also the formation of the single nucleus on the nucleation surface is effected in a very short time, so that nucleus is formed with a very low probability on the nonnucleation surface.

At the crystal growth stage, the exposed faces to the atoms of the crystal materials turn to comprise the nonnucleation surface, nucleation surface and crystal face, and after a sufficient progress of crystal growth turn to comprise the nonnucleation surface and crystal face. At this stage, the preparation conditions are set such that no nucleation takes place at all on the nonnucleation surface and the nucleus growth is effected on the crystal face only. Under such conditions, the nucleation becomes difficult to take place also on the nucleation surface remaining to be exposed at an earlier stage of the crystal growth. However, since the crystal growth is intended to be effected around the single nucleus on the nucleation surface formed at the initial nucleation stage, the nucleation on the other portion of nucleation surface is not required.

As for the conditions for controlling the nucleation, it is effective to control the ratio of the reactant gas to the nucleation suppressing gas.

An example of controlling these preparation conditions will be described below.

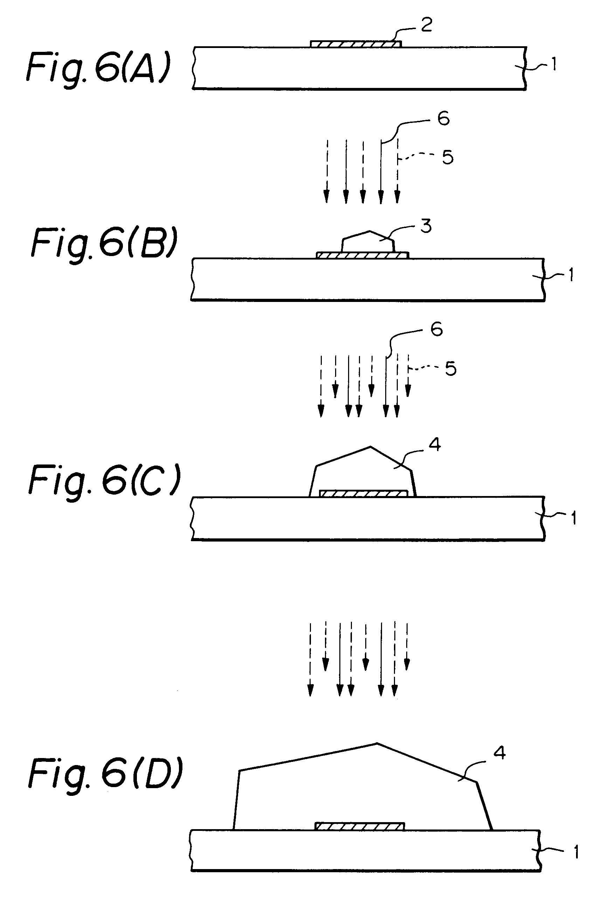

Figs. 6(A) to 6(D) are formation step views for explaining an example of the method of forming a crystal according to the first embodiment of the present invention.

First, as shown in Fig. 6(A), on an $SiO_2$ substrate 1, formed is an $Si_3N_4$ film (nucleation surface) 2 finely patterned to a size so as to allow a monocrystal to grow from a single nucleus on a nucleation surface, for example, to about 4 $\mu$m or less. Though not shown in the drawing, the $Si_3N_4$ film 2 was formed with arrangement in plurality on the $SiO_2$ substrate 1 depending on necessity. A single nucleus is formed on the respective $Si_3N_4$ films by nucleation treatment. As previously mentioned, in place of the $Si_3N_4$ film 2, there may be used a modified layer of $SiO_2$ formed by locally implanting $Si^+$ or $N^+$ ions on the $SiO_2$ substrate 1 at a density of e.g. $1 \times 10^{16}$ ions/cm$^2$ and with an energy of 50 keV or less.

Next, as shown in Fig. 6(B), a single nucleus of Si is formed on each of the $Si_3N_4$ film 2 by thermal decomposition or $H_2$-reduction of a reactant gas of a silicon hydride type represented by $Si_xH_{2(1+x)}$ ($x = 1, 2, 3,..$) or a chlorosilane type represented by $SiH_xCl_{4-x}$ ($x = 1, 2, 3, 4$) in an $H_2$-reductive atmosphere(film formation by vapor phase deposition). In this instance, the nucleation of the single nucleus is effected on the $SiO_2$ substrate 1 under the conditions of a substrate temperature (reaction temperature) of 990 °C and a reaction pressure of $2.10^4$ Pa (150 Torr) using e.g. a mixed gas of $SiH_2Cl_2/HCl/H_2$ = 1.2 ($\ell$/min)/ 0.6 ($\ell$/min)/ 100 ($\ell$/min). A monocrystal is then allowed to grow around this single nucleus by nucleation treatment. In cases a plurality of $Si_3N_4$ films 2 were formed on the $SiO_2$ substrate at pitches of 50 $\mu$m , 100 $\mu$m or 200 $\mu$m the growth rate in the lateral direction was found to be ca 0.3 $\mu$m/min for all the cases though somewhat variable depending on the pitch. However, when it is intended to allow a larger crystal to grow by employing a longer build-up time and a large exposed area of $SiO_2$ substrate 1, the nucleation of Si may start also on the $SiO_2$ substrate 1. It has been found that this occurs because of a short quantity of HCl in the above condition, but that, if the flow rate of HCl gas is increased to 1.6 $\ell$/min or more, the Si nucleus is not formed on the $SiO_2$ substrate 1 and on the $Si_3N_4$ film 2 as well. In this occasion, however, it has also been found possible to allow the Si monocrystal to grow around the single nucleus once formed. In the experiments for the selective epitaxial growth previously mentioned, a sufficient monocrystal growth rate has been attained even when the flow rate of HCl was increased to 3 times or more of the flow rate of $SiH_2Cl_2$ as the crystal forming treatment.

This is because while it is monocrystalline Si that serves as a seed in the selective epitaxial growth, the $Si_3N_4$ film 2 is used in the present invention as the seed. Namely, assuming respectively as $X_1$, $Y_1$ and $Z_1$ the adhesion coefficients of the Si atoms of Si, $Si_3N_4$ and $SiO_2$ produced by the chemical vapor deposition process, the following inequality relationship can be established:

$$X_1 > Y_1 \gg Z_1$$

The initial surface states are the face of $Si_3N_4$ film 2 (nucleation surface) and the face of the $SiO_2$ substrate 1 (nonnucleation surface) as already shown in Fig. 6(A), and once the single nucleus has been formed, the surface states thereafter turn to comprise the face of the $Si_3N_4$ film 2, the face of $SiO_2$ substrate 1 and the Si monocrystal face as shown in Fig. 6(B).

Accordingly, at a very initial nucleation state, the flow rate ratio of e.g. $SiH_2Cl_2$ gas (arrow 6) to HCl gas (arrow 5) is set to 1.2 ($\ell$/min)/ 1.6 ($\ell$/min) to give the conditions under which the nucleation can be effected only on the $Si_3N_4$ film 2 among the face of $Si_3N_4$ film 2 and the face of $SiO_2$ substrate 1. Since the formation of the single nucleus is effected in a very short time, no Si nucleus is formed at all on the $SiO_2$ substrate 1. For example, under the conditions of a substrate temperature of 990°C and a reduced pressure of $2.10^4$ Pa (150 Torr), only a single nucleus is formed on all the face of $Si_3N_4$ film 2 in several minutes, and no Si adheres on the face of $SiO_2$ substrate 1. Once the Si nucleus has been formed on the face of $Si_3N_4$ film 2, the crystal growth is thereafter continued by increasing the flow rate of HCl gas 5 to 1.6 $\ell$/min or more. The Si atoms that come flying undergo the epitaxial growth after adhesion onto the Si nucleus, and do not adhere at all on the face of $Si_3N_4$ film 2 and the face of $SiO_2$ substrate 1.

Next, as shown in Fig. 6(C), with further build-up of the Si atoms, the crystal grows occurs three-dimensionally and the exposed face of the $Si_3N_4$ film 2 disappears. Since the size of the $Si_3N_4$ film 2 is extremely small, the time required for the exposed face of $Si_3N_4$ film 2 to disappear can be of short time, and also since the adhesion coefficient is $X_1 > Y_1$, no nucleation takes place on the face of the $Si_3N_4$ film 2.

Next, as shown in Fig. 6(D), the crystal is allowed to further grow to a desired size. At this time, no nucleation takes place at all on the face of the $SiO_2$ substrate 1, and the Si nucleus continues to enlarge without impairing its crystallinity on the way of the growth.

In order to increase the crystal growth rate, effective is to raise the crystal growth temperature. However, there will be no change if the amount of the $SiH_2Cl_2$ gas 6 as a reaction gas is increased. For example, it is found that the raise of substrate temperature from 990°C to 1,030°C can bring about an increase of its growth rate of from 2 to about 3 times.

Next, specific examples of the crystal forming method of the present invention are described with referring to Figs. 6(A)-6(D).

Example 1

At first, as shown in Fig. 6(A), on an $SiO_2$ substrate 1 was formed as $Si_3N_4$ film 2 finely patterned to about 4 $\mu$m. Although not shown in the drawing, the $Si_3N_4$ film 2 was formed with arrangement in plurality on the $SiO_2$ substrate, and prepared were samples in which the distance between adjacent $Si_3N_4$ films 2 was set to 50 $\mu$m (Sample A), 100 $\mu$m (Sample B) or 200 $\mu$m (Sample C) to effect nucleation of a single nucleus on the $Si_3N_4$ film of each sample as follows.

That is, as shown in Fig. 6(B), within a reduced pressure film forming apparatus housing the $SiO_2$ substrate 1, a mixed gas of $SiH_2Cl_2$/HCl/$H_2$ = 1.2(l/min)/0.6(l/min)/100(l/min) was allowed to flow. In this occasion, the substrate temperature was set at 990°C and the pressure was set at $2.10^4$ Pa (150 Torr) (nucleation step). After this condition was kept for a few minutes, the flow rate of HCl gas was raised to 1.6 l/min or more. When this condition was kept for 80 minutes, Si monocrystals were formed on the $Si_3N_4$ films of all the samples as shown in Fig 6(D).

Example 2

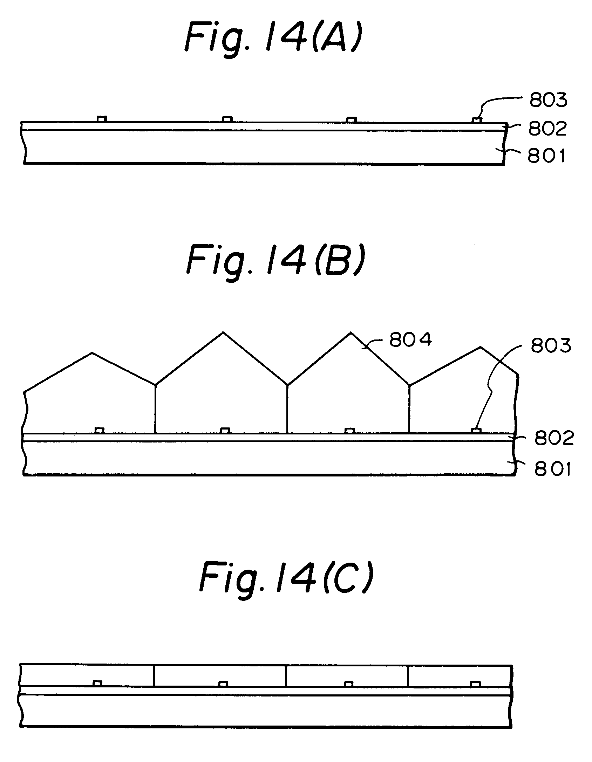

In the same manner as in the experiment described later, a substrate having $Si_3N_4$ films 803 of 1 $\mu$m square (as area) in a matrix with intervals of 150 $\mu$m arranged on $SiO_2$ film 802 formed on an Si wafer 801 was obtained (Fig. 14(A)). By employment of the crystal forming conditions A and B as described later, HCl was began to be flowed 4 minutes after initiation of the treatment, and flow rates were set at 1.65 l/min., 1.7 l/min ., respectively to perform crystal formation treatment under the four different conditions each for ten samples, for 200 min. On these samples,Si monocrystals 804 controlled in grain boundary position and grain particle size were found to be juxtaposed with formation of facets (Fig. 14(B)). Further, after thinning by polishing to a thickness of 10 $\mu$m (Fig. 14(C)), defect visualizing etching was applied and all the crystals formed on the wafer of 40 nuclei were observed by a SEM. As the result, no irregular crystal grain boundary was found, but the crystal grain bondaries were found to be formed at predetermined positions.

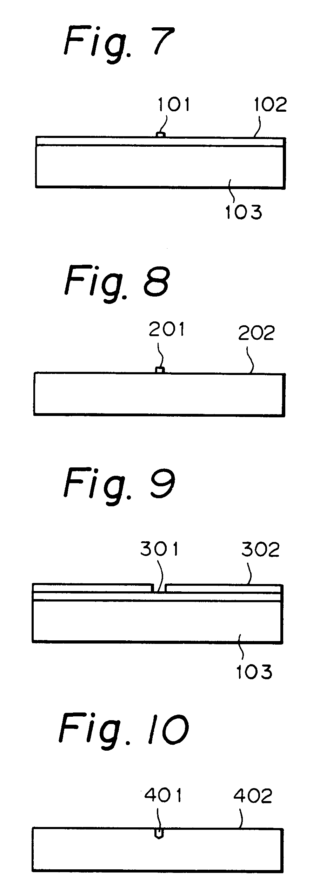

The substrate to be used in the present invention may have the nucleation surface and the non-nucleation surface, and the supporting member for these surfaces may be made of any desired material. To mention a constituent example of a substrate, as shown in Fig. 7, a surface layer 102 which comprises the non-nucleation surface may be arranged on the surface of support 103, and further a film of fine area which comprises the nucleation surface 101 may be formed on the surface layer 102.

Also, as shown in Fig. 8, the support 202 itself may comprise the non-nucleation surface 202, and a film of fine area which comprises the nucleation surface 201 may be formed on the support 202.

Also, as shown in Fig. 9, an underlying layer 301 which comprises the nucleation surface 301 may be arranged on the support 303, and a surface layer 302 which comprises the non-nucleation surface may be formed thereon, followed by removal of a part thereof to have the nucleation surface 301 exposed.

Also, as shown in Fig. 10, by ion implantation into the substrate 402 comprising the non-nucleation surface, the constitution may be made to form the nucleation surface.

In the present invention, the size of the nucleation surface is required to be sufficiently fine so that a monocrystal grows only from a single nucleus may be formed. Such size is determined depending on the material of the crystals to be formed, the material of the nucleation surface and monocrystal growth conditions, but it is preferably 10 $\mu$m or less, more preferably 5 $\mu$m or less. Optimally, it is 1 $\mu$m or less.

As the crystal formation treatment, vapor deposition is employed. This is because hydrogen chloride gas may be preferably used as a nucleation suppressing gas of which flow rate is increased in the crystal growth stage than in nucleation stage, thus different treatment conditions being attained between the nucleation and crystal growth stages.

In the present invention, by applying the above two-step crystal forming treatment a monocrystal of good quality is obtained at high yield.

In the following, an experiment leading to the discovery of the problem involved in the preparation of monocrystal is described.

A 12.7 cm (5 inch) monocrystalline Si wafer (support) 503 was subjected to thermal oxidation to have SiO$_2$ layer 502 with a thickness of about 200 nm (2000 Å) formed on the surface.

The presubstrate thus obtained was set in a reduced pressure vapor deposition device and Si$_3$N$_4$ layer was formed to a thickness of 40 nm (400 Å) on the above SiO$_2$ layer 502 according to the hot CVD method under the deposition conditions of:

pressure:               40 Pa (0.3 torr,)
gases employed:         SiH$_2$Cl$_2$ + NH$_3$ mixed gas,
flow rate ratio:        NH$_3$/SiH$_2$Cl$_2$ = 6,
substrate temperature:  800 °C.

Next, according to the lithographic technique, the above Si$_3$N$_4$ layer was subjected to patterning to form fine zones 501 of Si$_3$N$_4$ film which becomes the nucleation surface in a matrix arrangement of 50 x 100 with a size of about 1 $\mu$m and at a pitch of 100 $\mu$m to provide the substrate 504.

On the Si monocrystalline wafer having the non-nucleation surface comprising SiO$_2$ and the nucleation surfaces of 50 x 100 comprising Si$_3$N$_4$ thus provided on the surface, Si monocrystal formation treatment was performed according to hot CVD under the following conditions:

pressure:                        2.10$^4$ Pa (150 Torr).
gases employed and flow rates:   SiH$_2$Cl$_2$, 1.2 l/min.
                                 HCl, 1.2 l/min.
                                 H$_2$, 100 l/min.
temperature:                     950 °C.
treatment time:                  100 min.

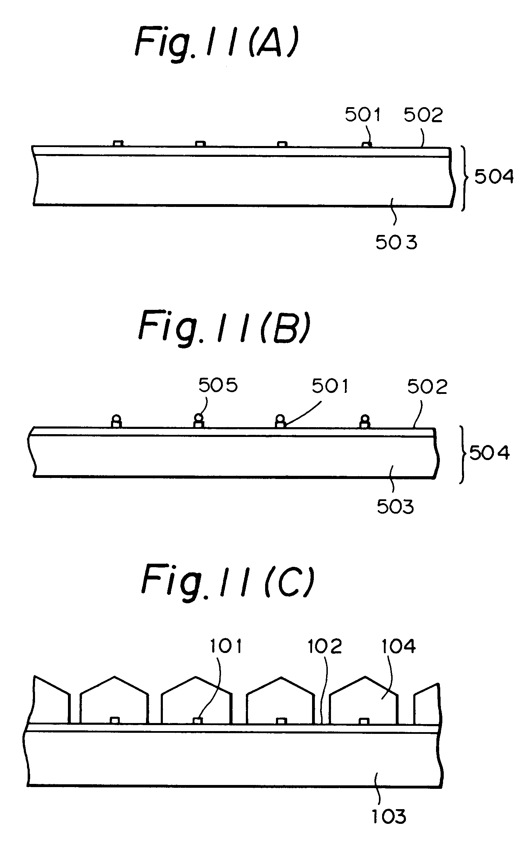

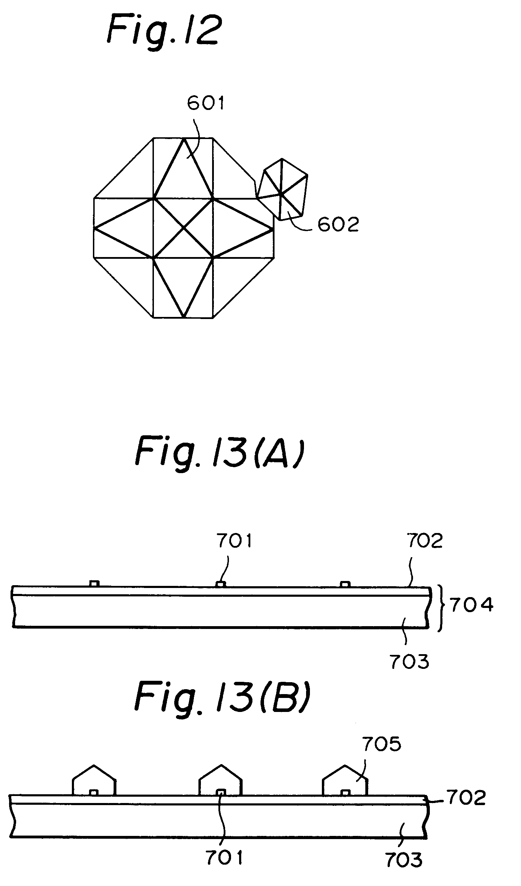

The Si monocrystalline wafer applied with the crystal formation treatment was taken out from the device and evaluation of the crystal was conducted by optical microscope and SEM. As the result, it was found that a Si monocrystal 505 with a grain size of 90 $\mu$m substantially without grain size distribution as shown in Fig. 11(B) was formed on the nucleation surfaces, but partially in some samples, something like a mass of Si 602 with small grain sizes was observed with the crystal defect appearing to be a grain boundary as the interface at the end of the Si monocrystal 601 as shown in Fig. 12. This may be concluded to be due to nucleation which happened to occur on the nonnucleation surface comprising SiO$_2$ on which no nucleation is desired to occur, and may be estimated to be a nucleus which happened to occur at the stage from Fig. 11(B) to Fig. 11(C), namely at the stage of nucleus monocrystal growth.

It has been found that, for preventing such happening nucleus generation SiO$_2$ layer, optimization of temperature, pressure, source gas and suitable addition of nucleation suppressing gas are effective. Above all, HCl gas having etching property may be effectively employed as a nucleation suppressing gas to be added appropriately.

The present inventors have reached the thought that it may be possible to cope with the nucleus which happens to be generated in a broad scope of range by performing the crystal formation treatment comprising two steps.

More specifically, in the nucleation step (the step of Fig. 11(A) to Fig. 11(B)) where a single crystal is selectively formed (several minutes from the beginning of crystal forming treatment), selective conditions should be determined for the nucleation surface and the non-nucleation surface as described above. In contrast, in the crystal growth step (the step of Fig. 11(B) to Fig. 11(C)) after the nucleation step, since a nucleus is formed on the nucleation surface, the flying atoms of the crystalline material can be grown extremely easily as compared with the case when the nucleation is formed on the nucleation surface. For, the attachment coefficient of the flying atoms is remarkably greater on the nucleus surface formed on the nucleation surface than on the nucleation surface. Thus, the scope for selecting selective preparation conditions becomes broader.

Next, the experiment for examination of the relationship for generation of happening nucleus and the preparation conditions is to be described.

A 12.7 cm (5 inch) Si monocrystal wafer 703 was subjected to thermal oxidation treatment to have a $SiO_2$ layer 704 with a thickness of about 200 nm (2000 Å) formed on the surface.

The presubstrate thus obtained was set in a reduced pressure vapor phase deposition device and a $Si_3N_4$ layer was formed to a thickness of 30 nm (300 Å) on the above $SiO_2$ layer according to the hot CVD method under the built-up conditions of:

| | |
|---|---|
| pressure: | 40 Pa (0.3 Torr), |
| gases employed: | $SiH_2Cl_2$ + $NH_3$ mixed gas, |
| flow rate ratio: | $NH_3/SiH_2Cl_2 = 6$, |
| substrate temperature: | 800 °C. |

Next, according to the lithographic technique, on the above $Si_3N_4$ was applied patterning to form fine zones of $Si_3N_4$ which become the nucleation surface in a matrix arrangement of 50 x 100 with a size of about 1 $\mu$m and a pitch of 150 $\mu$m, to provide a substrate 704 (Fig. 13(A)).

On the Si monocrystalline wafer having thus provided the non-nucleation surface comprising $SiO_2$ and the nucleation surfaces of 50 x 100 comprising $Si_3N_4$, the Si monocrystal forming treatment was conducted according to hot CVD under the following conditions. The HCl used as the parameter was continuously added from 5 minutes after initiation of the crystal formation treatment to completion (40 min.). Flow rate of HCl gas added in the step of crystal growth is varied as shown in Table A.

After the crystal formation treatment, samples were taken out from the device for examination of presence of happening nucleus by an optical nucleus. The results are shown in Table B.

As clearly shown in Table B, a remarkable change was observed as related to the HCl flow rate with a critical level of 1.6 l/min, and it has been found that no happening nucleus was generated in the direction of larger amount than that level. On the other hand, there is substantially no change between the crystal growth conditions A and B in which only the pressure is different and the crystal growth conditions A and C in which only the temperature is different. From the above results, HCl acts as the etching gas, and may be estimated to have the action of removing generation of happening nucleus on the non-nucleation surface.

As described in detail above, according to the method of forming crystals of the present invention, a single crystal is formed on a material of different kind in the initial step of nucleation with good efficiency, while formation of a happening nucleus on the built-up film is prevented in the crystal growth step, whereby a crystal can be prepared with high yield with the single nucleus formed on the fine material of different kind as the center.

TABLE A

| Condition | A | B | C |
|---|---|---|---|
| Pressure | $2.10^4$ Pa (150 Torr) | $2.710^4$ Pa (200 Torr) | $2.10^4$ Pa (150 Torr) |
| Temperature | 950 °C | 950 °C | 1000 °C |
| Nucleation suppressing gas | HCl : 1.0, 1.5, 1.6, 1.7, 2.0 1/min (from 5 to 40 min) | | |
| Source gas | $SiH_2Cl_2$ : 1.2 1/min | | |
| Carrier gas | $H_2$ : 100 1/min | | |
| Treatment time | 40 min | | |

TABLE B

| HCl (1/min) Condition | 1.0 | 1.5 | 1.6 | 1.7 | 2.0 |
|---|---|---|---|---|---|
| A | 10/10 | 9/10 | 1/10 | 0/10 | 0/10 |
| B | 10/10 | 7/10 | 2/10 | 0/10 | 0/10 |
| C | 10/10 | 8/10 | 1/10 | 0/10 | 0/10 |

$$\left( \frac{\text{Wafer Having Happening Nucleus}}{\text{Wafer Subjected to Nucleation Treatment}} \right)$$

## Claims

1. A method of forming a crystal on a substrate having a nucleation surface of amorphous material and a nonnucleation surface in a film forming space, the nucleation surface having a larger nucleation density than the nonnucleation surface and an area small enough to support the formation of only a single nucleus from which a single crystal can be grown, said method comprising:

forming said single nucleus on the nucleation surface of said substrate using a chemical vapor deposition method by introducing a crystal forming gas and a nucleation suppressing gas into the film forming space, the ratio of crystal forming gas to nucleation suppressing gas being sufficient to effect formation of said single nucleus on said nucleation surface; and

increasing the amount of said nucleation suppressing gas to inhibit growth on said non-nucleation surface, and effecting growth of said single crystal by growing single crystal material from said single nucleus on said nucleation surface.

2. The method according to claim 1, comprising forming said nucleation surface by implanting ions onto said nonnucleation surface, thereby modifying said nonnucleation surface.

3. The method as claimed in either preceding claim when performed using a nucleation surface of size 10 $\mu$m or less.

4. The method as claimed in any one of the preceding claims wherein the nucleation surface has a nucleation density larger than that of the nonnucleation surface, as stated, by a factor $10^2$ or more.

5. The method as claimed in any one of the preceding claims wherein the substrate is of silicon oxide, the nucleation surface is of silicon, gallium arsenide, or silicon nitride, and the single crystal grown is of silicon, tungsten, gallium arsenide or indium phosphide.

**Patentansprüche**

1. Verfahren zur Bildung eines Kristalls auf einem Träger mit einer Oberfläche für die Kristallkeimbildung aus amorphem Material und einer Oberfläche für die Nicht-Kristallkeimbildung in einem Filmbildungsraum, wobei die Oberfläche für die Kristallkeimbildung eine größere Dichte der Kristallkeimbildung als die Oberfläche für die Nicht-Kristallkeimbildung und eine Flächenausdehnung aufweist, die klein genug ist, um die Bildung von nur einem einzelnen Kristallkeim, aus dem ein Einkristall gezüchtet werden kann, zu unterstützen, wobei das Verfahren umfaßt:

Bildung des einzelnen Kristallkeims auf der Oberfläche für die Kristallkeimbildung des Trägers unter Verwendung des Verfahrens der chemischen Abscheidung aus der Gasphase (CVD-Verfahren) mittels Einleitens eines Gases für die Kristallbildung und eines Gases zur Unterdrückung der Kristallkeimbildung in den Filmbildungsraum, wobei das Verhältnis von Gas für die Kristallbildung zu Gas zur Unterdrückung der Kristallkeimbildung ausreichend ist, um die Bildung des einzelnen Kristallkeims auf der Oberfläche für die Kristallkeimbildung zu bewirken; und

Vergrößerung der Menge des Gases zur Unterdrückung der Kristallkeimbildung, um das Wachstum auf der Oberfläche für die Nicht-Kristallkeimbildung zu hemmen und ein Wachstum des Einkristalls durch Wachsenlassen von einkristallinem Material auf dem einzelnen Kristallkeim auf der Oberfläche für die Kristallkeimbildung zu bewirken.

2. Verfahren nach Anspruch 1, umfassend die Bildung der Oberfläche für die Kristallkeimbildung durch Implantieren von Ionen in die Oberfläche für die Nicht-Kristallkeimbildung, wodurch die Oberfläche für die Nicht-Kristallkeimbildung modifiziert wird.

3. Verfahren nach einem der vorstehenden Ansprüche, wenn es unter Verwendung einer Oberfläche für die Kristallkeimbildung mit einer Größe von 10 $\mu$m oder weniger ausgeführt wird.

4. Verfahren nach einem der vorstehenden Ansprüche, wobei die Oberfläche für die Kristallkeimbildung eine Dichte der Kristallkeimbildung aufweist, die, wie angegeben, um einen Faktor von $10^2$ oder mehr, höher als die der Oberfläche für die Nicht-Kristallkeimbildung ist.

5. Verfahren nach einem der vorstehenden Ansprüche, wobei der Träger aus Siliziumoxid, die Oberfläche für die Kristallkeimbildung aus Silizium, Galliumarsenid oder Siliziumnitrid besteht und der gezüchtete Einkristall aus Silizium, Wolfram, Galliumarsenid oder Indiumphosphid besteht.

**Revendications**

1. Procédé pour former un cristal sur un substrat possédant une surface de nucléation de matière amorphe et une surface de non-nucléation dans un espace de formation de film, la surface de nucléation ayant une densité de nucléation supérieure à celle de la surface de non-nucléation et ayant une surface suffisamment petite pour provoquer la formation d'un seul germe à partir duquel peut se développer un seul cristal, ledit procédé comprenant :

   la formation de ce seul germe sur la surface de nucléation dudit substrat au moyen d'un procédé de déposition chimique en phase vapeur par introduction d'un gaz de formation de cristal et d'un gaz de suppression de nucléation dans l'espace de formation de film, le rapport du gaz de formation de cristal au gaz de suppression de nucléation étant suffisant pour provoquer la formation de ce seul germe sur ladite surface de nucléation ; et

   l'augmentation de la quantité dudit gaz de suppression de nucléation pour inhiber la croissance sur ladite surface de non-nucléation, et la conduite de la croissance de ce seul cristal par croissance de la seule matière cristalline de ce seul germe sur ladite surface de nucléation.

2. Procédé suivant la revendication 1, comprenant la formation de la surface de nucléation par implantation d'ions sur la surface de non-nucléation, ce qui provoque une modification de ladite surface de non-nucléation.

3. Procédé suivant l'une ou l'autre revendication précédente, lorsqu'il est mis en oeuvre en utilisant une surface de nucléation ayant un diamètre égal ou inférieur à 10 $\mu$m.

4. Procédé suivant l'une quelconque des revendications précédentes, dans lequel la surface de nucléation possède une densité de nucléation supérieure à celle de la surface de non-nucléation, de la manière indiquée, d'un facteur égal ou supérieur à $10^2$.

5. Procédé suivant l'une quelconque des revendications précédentes, dans lequel le substrat est constitué d'oxyde de silicium, la surface de nucléation est constituée de silicium, d'arséniure de gallium ou de nitrate de silicium, et le monocristal formé est un monocristal de silicium, de tungstène, d'arséniure de gallium ou de phosphure d'indium.

## Fig. 1

## Fig. 2(A)

## Fig. 2(B)

# Fig. 3

## Fig. 4(A)

## Fig. 4(B)

## Fig. 4(C)

## Fig. 4(D)

# Fig. 5(A)

# Fig. 5(B)

*Fig. 6(A)*

*Fig. 6(B)*

*Fig. 6(C)*

*Fig. 6(D)*

## Fig. 7

101    102

103

## Fig. 8

201    202

## Fig. 9

301    302

103

## Fig. 10

401    402

## Fig. I I (A)

501   502

504

503

## Fig. I I (B)

505   501   502

504

503

## Fig. I I (C)

101   102   104

103

*Fig. 12*

601

602

*Fig. 13(A)*

701        702

704

703

*Fig. 13(B)*

705

702

701        703

## Fig. 14(A)

## Fig. 14(B)

## Fig. 14(C)